# FASCICULE DE BREVET EUROPEEN

(11) **EP 0 860 905 B1**
(45) Date de publication et mention de la délivrance du brevet: **10.07.2002**
(21) Numéro de dépôt: 98201407.8
(22) Date de dépôt: 07.04.1997
(51) Int. Cl.: H01R 13/514, H01R 12/18, G06K 7/00, H05K 5/02

(54) **Boîtier équipé d'un connecteur pour le raccordement d'une carte à circuit(s) intégré(s)**
Gehäuse ausgerüstet mit einem Verbinder für IC-Karte
Housing equipped with a connector for integrated circuit card

(30) Priorité: 18.04.1996 FR 9604842
(43) Date de publication de la demande: 26.08.1998
(62) Demande divisionnaire de: 97923269.1
(73) Titulaire: ITT MANUFACTURING ENTERPRISES, INC., Wilmington, Delaware 19801 (US)
(72) Inventeur: Bricaud, Hervé, 39100 Dole (FR); Biermann, Werner, 73650 Winterbach (DE)
(74) Mandataire: Kohn, Philippe

(56) Documents cités:
- EP-A- 0 480 334
- DE-A- 4 138 342
- DE-U- 29 505 678
- PATENT ABSTRACTS OF JAPAN vol. 16, no. 318 (E-1232), 13 juillet 1992 (1992-07-13) & JP 04 092380 A (FUJI ELECTRIC)

## Description

La présente invention concerne un boîtier électronique comportant un connecteur électrique pour relier une carte à circuit(s) intégré(s) à contact.

La connexion d'une carte à puce avec un quelconque dispositif électronique d'exploitation de données qu'elle contient est couramment assurée par l'intermédiaire d'un connecteur de conception générale connue qui comporte un support en matériau isolant comportant un logement ouvert dans sa face supérieure qui reçoit la carte à puce comportant sur sa face principale des plages conductrices qui coopèrent avec les extrémités de contact d'éléments de contact électrique agencées dans le fond du logement du support isolant du connecteur.

On connaît du document DE-U-29.505.678 un boîtier de raccordement électronique au format carte "PCMCIA" pour connecter une carte à circuits intégrés, ou carte à puce, à contact à un appareil électronique comportant une fente complémentaire au format "PCMCIA". Ce boîtier possède les caractéristiques du préambule de la revendication 1.

On connaît par ailleurs du document DE-A-4.138.432 un connecteur électrique pour une carte à puce pouvant par exemple être intégré dans un boîtier électronique du type mentionné ci-dessus.

Ce type de connecteur comporte des moyens de butée agencés dans une paroi parallèle au plan de la carte et qui coopèrent avec un pan coupé de la carte à puce qui, pour certaines applications, constitue un moyen de détrompage de la position de la carte dans le connecteur.

Ce document propose aussi des moyens d'extraction de la carte faisant appel à une déformation élastique de la carte qui est nuisible à la fiabilité de cette dernière, et ces moyens sont complexes et impossibles à intégrer avec le connecteur dans un boîtier au format "PCMCIA".

L'invention a pour but de proposer une nouvelle conception d'un boîtier électronique de raccordement intégrant un connecteur électrique pour une carte à puce qui permet de maintenir la carte en position introduite et d'éviter son échappement accidentel.

Dans ce but, l'invention propose un boîtier de raccordement électronique selon la revendication 1.

Selon d'autres caractéristiques préférentielles du boîtier selon l'invention :
- le connecteur comporte un support en matériau isolant qui comporte un logement ouvert dans sa face supérieure, délimité par deux bords parallèles à la direction d'introduction de la carte et transversalement par au moins un bord arrière et qui reçoit au moins en partie la carte comportant sur sa face principale inférieure des plages conductrices qui coopèrent avec les extrémités de contact d'éléments dé contact électrique, agencées dans le fond du logement du support, lorsque la carte est dans sa position de raccordement dans laquelle son bord transversal arrière est en butée contre le bord transversal arrière du logement, et la face interne en vis à vis de la paroi supérieure, dans laquelle est formé le bossage, est adjacente à la face supérieure du support du connecteur ;
- des moyens d'extraction de la carte comportent une entaille formée dans la paroi supérieure et qui s'étend parallèlement à la direction d'introduction de la carte pour permettre d'agir sur la carte en vue de provoquer son coulissement à l'intérieur du logement dans le sens correspondant à son extraction ;
- l'entaille s'étend au moins en partie au droit du bord transversal arrière de la carte lorsque cette dernière est en position introduite pour permettre l'introduction d'un outil d'extraction qui coopère avec le bord transversal arrière de la carte ;
- le boîtier comporte une fente pour l'introduction, ou l'extraction, de la carte dans le boîtier selon une direction sensiblement parallèle au plan de la carte;
- en position introduite, la carte est agencée entièrement à l'intérieur du boîtier ;
- en position introduite dans le boîtier, et ainsi en position de raccordement dans le logement du connecteur , le bord transversal avant de la carte est situé entièrement à l'intérieur du boîtier, c'est-à-dire légèrement en retrait vers l'intérieur par rapport au bord principal de la fente d'introduction.

D'autres caractéristiques et avantages de l'invention apparaîtront à la lecture de la description détaillée qui suit pour la compréhension de laquelle on se reportera aux dessins annexés dans lesquels :
- la figure 1 est une vue en perspective éclatée des principaux composants d'un boîtier de raccordement électronique équipé d'un connecteur pour le raccordement d'une carte ;
- la figure 2 est une vue de détail en perspective du boîtier de raccordement électronique illustré à la figure 1 qui illustre à plus grande échelle l'agencement de la fente d'introduction de la carte dans le boîtier ;
- la figure 3 est une vue de dessus d'un premier mode de réalisation d'un connecteur pour carte à puce destiné à être intégré dans un boîtier de raccordement électronique;
- la figure 4 est une vue latérale selon la flèche F4 de la figure 3 ;
- la figure 5 est une vue latérale selon la flèche F5 de la figure 3 ;
- la figure 6 est une vue de dessus, avec arrachements partiels, du boîtier de raccordement électronique et qui illustre l'implantation du connecteur sur la plaque à circuit imprimé et à proximité de la fente d'introduction de la carte ; et
- la figure 7 est une vue en section partielle selon la ligne 7-7 de la figure 6.

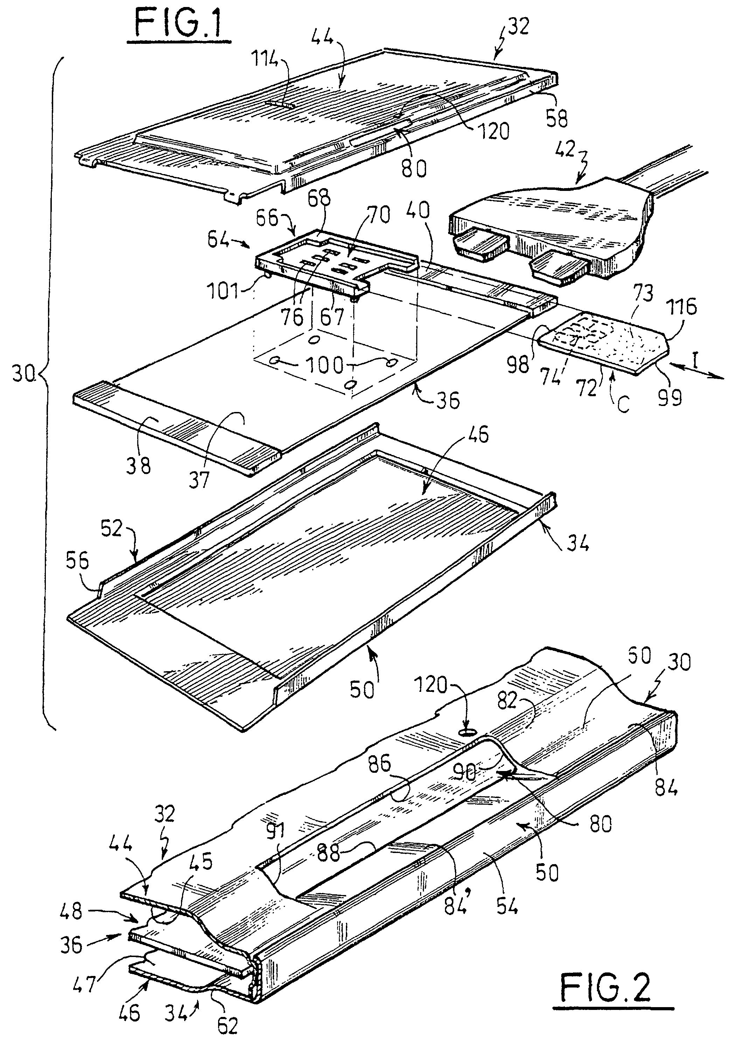

On a représenté à la figure 1 un boîtier 30 de raccordement électronique, de conception générale connue, qui est essentiellement constitué par une coquille métallique comportant une demi-coquille supérieure 32 et une demi-coquille inférieure 34 dont chacune est une pièce en tôle découpée, emboutie et pliée.

Les formes et les dimensions de la coquille en deux parties 32, 34 sont conformes à la norme PCMCIA qui, outre ses dimensions, détermine aussi les détails de conformation de la coquille de manière à permettre son introduction dans une fente normalisée (non représentée) de forme complémentaire appartenant par exemple à un ordinateur personnel.

A l'intérieur du boîtier 30, entre les demi-coquilles 32 et 34, est agencé une plaque à circuit imprimé 36 qui s'étend parallèlement au plan général du boîtier et qui porte, à chacune de ses extrémités longitudinales opposées, des connecteurs 38, 40, illustrés de manière schématique sur la figure 1, l'un ou l'autre des connecteurs pouvant, selon les applications, être remplacé par un élément de même dimension constituant un bouchon de fermeture du boîtier 30 à son extrémité longitudinale correspondante.

La plaque à circuit imprimé qui constitue la plaque intermédiaire du boîtier peut recevoir, sur ses deux faces, des composants électroniques (non représentés).

Comme on l'a représenté sur la figure 1, l'un des connecteurs 40 peut par exemple être conçu pour permettre le branchement d'une prise 42 qui assure le raccordement du boîtier 30 par exemple avec une ligne de télécommunication.

La demi-coquille supérieure 32 délimite une paroi principale supérieure plane 44 qui, en coopération avec la paroi principale inférieure plane 46 de la demi-coquille inférieure 34, délimite une cavité interne 48 (voir figure 2) à l'intérieur de laquelle s'étend la plaque à circuit imprimé 36, parallèlement aux parois 44 et 46 et sensiblement à mi-hauteur entre les faces internes en vis-à-vis 45 et 47 des parois 44 et 46.

Selon la conception normalisée du boîtier 30, celui-ci est délimité transversalement par deux parois latérales opposées 50 et 52, qui sont parallèles à la direction générale longitudinale du boîtier 30 et qui sont ici constituées par des bords rabattus verticaux 54 et 56 de la demi-coquille inférieure 34 qui sont sertis autour des bords latéraux en vis-à-vis de la demi-coquille supérieure 32 dont l'un 58 est illustré à la figure 1.

Le boîtier 30 peut être réalisé avec une coquille en une seule pièce.

Les parois latérales 50 et 52 du boîtier de raccordement 30 sont conformées en forme de rails de guidage du boîtier 30 dans des glissières correspondantes (non représentées) appartenant à la fente normalisée destinée à recevoir le boîtier 30.

A cet effet, les portions d'extrémité latérale des demi-coquilles supérieure 32 et inférieure 34 sont déformées 60, 62 pour conférer aux parois latérales 50 et 52 une hauteur réduite par rapport à la hauteur globale du boîtier 30, c'est-à-dire son épaisseur dans sa partie centrale.

Un connecteur 64 destiné à recevoir une carte C à circuit(s) intégré(s) à contact du type "MICRO SIM" est agencé à l'intérieur du boîtier 30.

Selon une conception connue, qui est par exemple décrite et représentée dans la demande de brevet français FR-A-2.742.561, le connecteur 64 est constitué pour l'essentiel par un support en matériau isolant 66 qui délimite dans sa face supérieure 68 un logement 70 de forme complémentaire de celui de la carte C et qui est destiné à recevoir au moins en partie cette dernière dont la face inférieure 72 comporte des plages conductrices 74 qui, lorsque la carte C est en position introduite dans le logement 70, sont en contact avec des extrémités de contact 76 appartenant à des lames de contact 78 du connecteur.

Le connecteur 66 est prévu pour être monté avec la face inférieure 67 de l'isolant 66 en appui sur la face supérieure 37 de la plaque à circuit imprimé 36.

Une fois le boîtier 30 assemblé et fermé avec le connecteur 64 porté par la plaque à circuit imprimé 10 et afin de permettre l'introduction et ou l'extraction de la carte C dans le connecteur 64, il est prévu une fente 80 qui, dans le mode de réalisation préféré illustré aux figures, est agencée au voisinage de l'une des parois latérales 50 du boîtier de raccordement 30.

Plus particulièrement, et comme on peut le voir en détail sur la figure 2, la fente d'introduction 80 s'étend pour l'essentiel dans la portion inclinée 82 de la partie latérale de la demi-coquille supérieure 32 qui relie la paroi principale supérieure 44 au pli 60 qui s'étend dans la portion plane 84 correspondant à la portion latérale d'épaisseur réduite du boîtier 30.

La portion 84' de la partie 84, qui s'étend au droit de la fente 80 découpée dans la partie inclinée 82, est légèrement déformée verticalement vers le bas par rapport au plan général de la partie 84.

La fente d'introduction 80 est ainsi délimitée par deux bords principaux supérieurs 86 et 88 et par deux bords d'extrémité 90 et 92.

Dans ce mode de réalisation du connecteur 64, celui-ci comporte, sur sa face inférieure 67, quatre pieds 101 en forme de pions cylindriques qui sont destinés, d'une part, à assurer le positionnement et la fixation du connecteur 64 sur la plaque à circuit imprimé 36, qui comporte à cet effet des trous correspondants 100 à travers laquelle s'étendent les pieds 101 et, d'autre part, à permettre au connecteur 64 d'assurer une fonction d'entretoise entre les plaques principales supérieure 44 et inférieure 46 du boîtier 30 afin d'éviter un écrasement intempestif du boîtier 30.

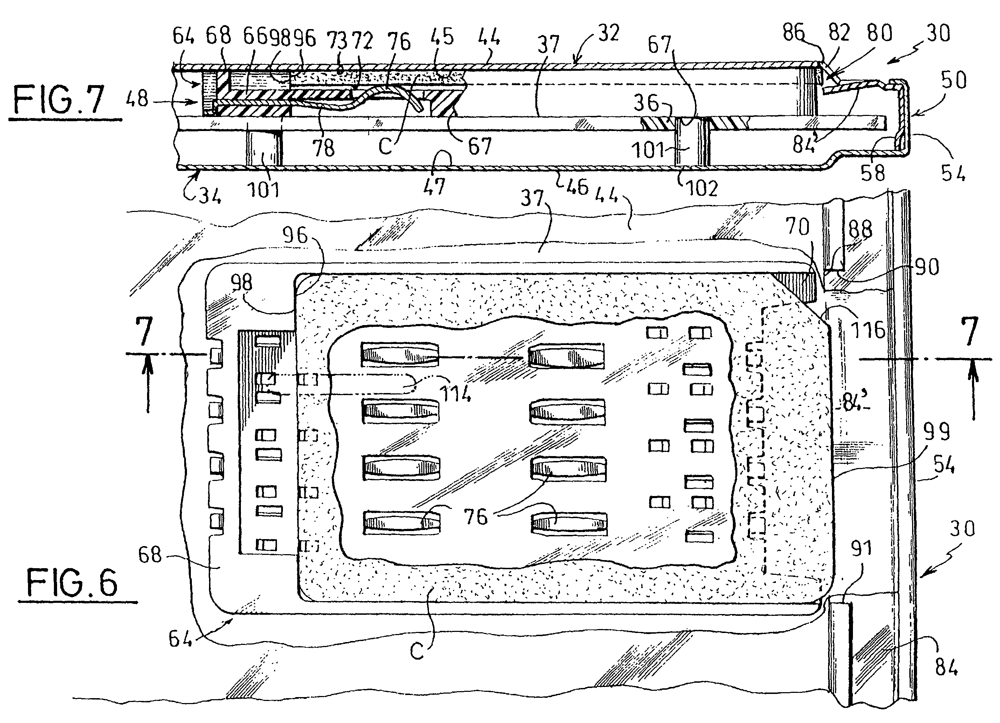

A cet effet, et comme on peut le voir notamment sur la figure 7, la hauteur des pieds 101 en forme de pions cylindriques formant entretoise est telle que la face d'extrémité inférieure 102 de chaque pied 101 est en contact avec la face interne 47 de la paroi inférieure 46 tandis que la face supérieure plane 68 du support isolant 66 du connecteur 64 est en appui contre la face interne en vis-à-vis 45 de la paroi supérieure 44.

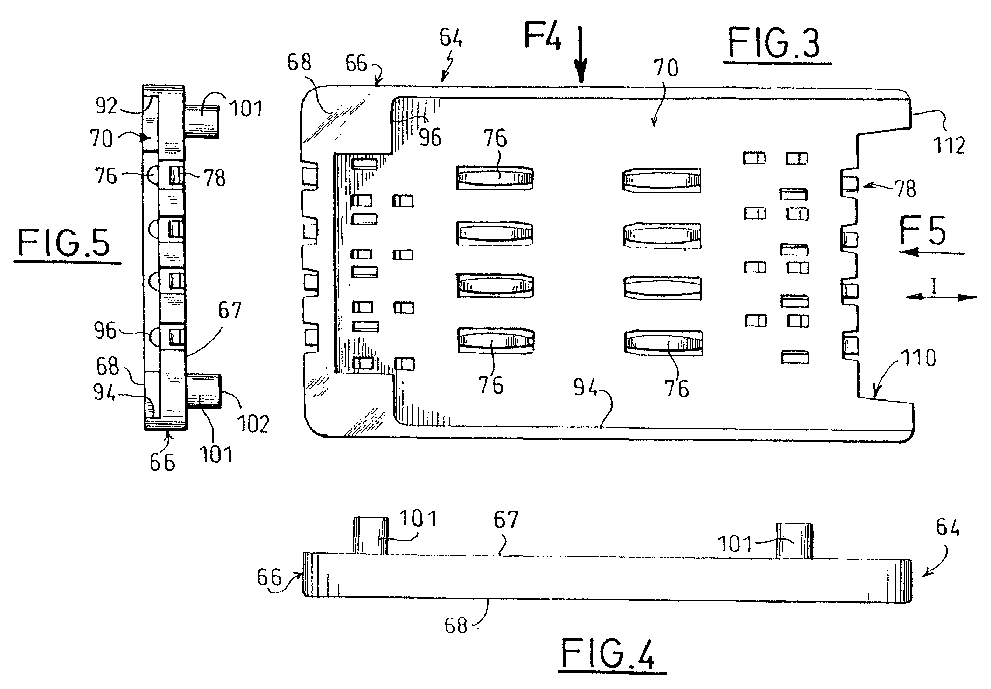

Comme on peut le voir à la figure 3, la conception du connecteur 64, qui comporte un dégagement 110 formé dans son bord avant 112, et son positionnement sur la carte à circuit imprimé 36, par rapport à la fente 80, sont tels que les extrémités de raccordement des lames de contact 78 sont situées en retrait par rapport à la zone d'accès constituée par la fente 80 évitant ainsi tout risque de court-circuit accidentel en cas d'introduction d'un objet métallique dans la fente 80.

Comme on peut le voir aussi aux figures 6 et 7, lorsque la carte C est en position introduite dans le boîtier et ainsi en position de raccordement dans le logement 70 du connecteur 64, son bord transversal avant 99 est situé entièrement à l'intérieur du boîtier 30, c'est-à-dire légèrement en retrait vers l'intérieur par rapport au bord principal supérieur 86 de la fente d'introduction 80. Afin de faciliter l'introduction à fond de la carte, on peut prévoir une découpe supplémentaire dans le bord de la fente 80.

Le boîtier 30 équipé du connecteur 64 présente ainsi une "silhouette" extérieure, après introduction de la carte C, qui est identique à celle d'un boîtier classique de manière à permettre son introduction dans une fente correspondante d'un ordinateur personnel.

Les dimensions extrêmement réduites de la fente d'introduction 80 ne modifient pas la structure générale du boîtier 30, c'est-à-dire ni sa rigidité, et la fente n'affecte pas la fonction de blindage électromagnétique que le boîtier assure par rapport aux composants (non représentés) portés par la plaque à circuit imprimé 36.

Selon le mode de réalisation illustré aux figures 1 à 7, afin de permettre l'extraction de la carte C hors du boîtier 30, il est prévu dans la plaque principale supérieure 44 une entaille ou rainure d'extraction 114, qui est illustrée en trait mixte à la figure 6, qui s'étend transversalement par rapport au boîtier 30, c'est-à-dire parallèlement à la direction I d'introduction ou d'extraction de la carte. L'entaille 114 est positionnée de manière à s'étendre de part et d'autre du bord transversal arrière 98 de la carte C et, de préférence, en vis-à-vis d'une zone du connecteur 64 ne comportant pas de parties métalliques appartenant aux lames de contact 78.

Ainsi, il est possible d'introduire un outil de petite dimension dans l'entaille 114 pour agir sur le bord transversal arrière 98 de la carte C afin de la repousser hors de son logement 70, c'est-à-dire en la faisant coulisser de la gauche vers la droite en considérant la figure 6, sur la course permise par la longueur de l'entaille 114 de manière que son bord transversal avant 99 sorte au moins en partie du boîtier 30 par la fente 80 de façon que, à l'issue de cette première phase d'extraction, l'utilisateur puisse attraper la carte pour l'extraire entièrement du boîtier 30.

Selon la définition normalisée des cartes "MICRO SIM", dont un exemple est illustré dans le cadre de la présente description, la carte C comporte au voisinage de son bord transversal avant 99 un pan coupé 116 qui, pour certaines applications, constitue un moyen de détrompage de la position de la carte C dans son connecteur.

Afin de maintenir la carte C en position introduite dans le boîtier 30 et éviter son échappement accidentel hors du boîtier, même partiel, il peut être prévu un bossage 120 formé dans la paroi principale supérieure 44 au droit du pan coupé 116 et qui s'étend, sur une faible hauteur, à l'intérieur de la cavité 48, pour constituer une butée qui s'étend en regard du pan coupé 116.

Lors de l'extraction de la carte au moyen d'un outil introduit dans l'entaille 114, l'utilisateur doit appliquer un effort légèrement plus important de manière que, par une légère déformation élastique de la partie correspondante de la paroi supérieure 44, la butée constituée par le bossage 120 s'efface lors du passage du pan coupé 116 puis de la face supérieure 73 de la carte C.

## Revendications

1. Boîtier de raccordement électronique (30) à parois supérieure (32) et inférieure (34) qui délimitent entre elles une cavité (48) à l'intérieur de laquelle est agencé un connecteur (64), qui comporte un support (66) en matériau isolant, pour relier électriquement au boîtier une carte à circuit(s) intégré(s) à contact (C) du type comportant au voisinage de son bord transversal avant (99) un pan coupé (116) qui pour certaines applications constitue un moyen de détrompage de la position de la carte (C) dans le connecteur, et **caractérisée en ce que** la paroi principale supérieure (44) comporte, sur sa face interne (45), un bossage (120) qui, lorsque la carte (C) est en position introduite, s'étend au droit du pan coupé (116), sur une faible hauteur, pour constituer une butée qui s'étend en regard du pan coupé (116) pour éviter tout échappement accidentel de cette dernière, et **en ce que**, lors de l'extraction de la carte, par une légère déformation élastique de la partie correspondante de la paroi supérieure (44), la butée constituée par le bossage (120) s'efface lors du passage du pan coupé (116) puis de la face supérieure (73) de la carte (C).

2. Boîtier de raccordement électronique selon la revendication précédente, **caractérisé en ce que** le matériau isolant (66) comporte un logement (70) ouvert dans sa face supérieure (68), délimité par deux bords (92, 94) parallèles à la direction d'introduction de la carte et transversalement par au moins un bord arrière (96) et qui reçoit au moins en partie la carte (C) comportant sur sa face principale inférieure (72) des plages conductrices (74) qui coopèrent avec les extrémités de contact (76) d'éléments (78) de contact électrique, agencées dans le fond du logement (70) du support, lorsque la carte (C) est dans sa position de raccordement dans laquelle son bord transversal arrière (98) est en butée contre le bord transversal arrière (96) du logement, et **en ce que** la face interne en vis à vis (45) de la paroi supérieure (44), dans laquelle est formé le bossage (120), est adjacente à la face supérieure (68) du support (66) du connecteur (64).

3. Boîtier de raccordement électronique selon l'une quelconque des revendications précédentes, **caractérisé en ce que** des moyens d'extraction de la carte (C) comportent une entaille (114) formée dans la paroi supérieure (44) et qui s'étend parallèlement à la direction (I) d'introduction de la carte (C) pour permettre d'agir sur la carte (C) en vue de provoquer son coulissement à l'intérieur du logement (70) dans le sens correspondant à son extraction.

4. Boîtier de raccordement électronique selon la revendication3, **caractérisé en ce que** l'entaille (114) s'étend au moins en partie au droit du bord transversal arrière (98) de la carte (C) lorsque cette dernière est en position introduite pour permettre l'introduction d'un outil d'extraction qui coopère avec le bord transversal arrière de la carte.

5. Boîtier de raccordement électronique selon l'une quelconque des revendications précédentes, **caractérisé en ce qu'**il comporte une fente (80) pour l'introduction, ou l'extraction, de la carte (C) dans le boîtier selon une direction (I) sensiblement parallèle au plan de la carte (C).

6. Boîtier de raccordement électronique selon la revendication précédente, **caractérisé en ce que**, en position introduite, la carte (C) est agencée entièrement à l'intérieur du boîtier (30).

7. Boîtier de raccordement électronique selon la revendication précédente, **caractérisé en ce que**, en position introduite dans le boîtier, et ainsi en position de raccordement dans le logement (70) du connecteur (64), le bord transversal avant (99) de la carte est situé entièrement à l'intérieur du boîtier (30), c'est-à-dire légèrement en retrait vers l'intérieur par rapport au bord principal de la fente d'introduction (80).

## Patentansprüche

1. Elektronisches Anschlußgehäuse (30) mit einer Oberen (32) und einer unteren Wandung (34), die zwischen sich einen Hohlraum (48) abgrenzen, in dem innenliegend ein Stecker (64) ausgebildet ist, der einen Sockel (66) aus isolierenden Material umfasst, zum elektrischen verbinden des Verbindungsgehäuse (30) mit einer Kontaktkarte (C) mit integrierten/integriertem Schaltkreis(en) von der Art, umfassend benachbart der transversalen Vorderkante (99) davon, eine abgeschrägte Kante (116), die für gewisse Anwendungen ein Mittel bildet zur Unverwechselbarkeit der Position der Kontaktkarte (C) in dem Stecker (64), **dadurch gekennzeichnet, dass** eine obere Hauptwandung (44), auf deren Innenseite (45) einen Höcker (120) umfasst, der, wenn die Kontaktkarte (C) in einer eingeführten Position ist, sich an der abgeschrägten Kante (116) mit geringer Höhe erstreckt, um einen Anschlag zu bilden, der sich in Richtung der abgeschrägten Kante (116) erstreckt, um ein zufälliges Entweichen letzterer zu vermeiden, und daß beim Herausziehen der Kontaktkarte (C) durch eine leichte elastische Verformung des entsprechenden Abschnitts der oberen Hauptwandung (44), der durch den Höcker (120) gebildete Anschlag beim passieren der abgeschrägten Kante (116) und einer oberen Fläche (73) der Kontaktkarte (C) verschwindet.

2. Elektronisches Anschlußgehäuse nach Anspruch 1, **dadurch gekennzeichnet, dass** das isolierende Material eine Aufnahme (70) in einer offenen Oberseite (68) umfasst, begrenzt durch zwei in Einführungsrichtung der Kontaktkarte parallele Ränder (92. 94), und quer, durch zumindest einen Hinterrand (96), die zumindest abschnittsweise die Kontaktkarte (C) aufnimmt, die an einer unteren Hauptfläche (72) Kontaktbereiche (74) umfasst, die mit Kontaktenden (76) von Kontaktelementen (78) wechselwirken, im Boden der Aufnahme (70) des Sockels ausgebildet, wenn die Kontaktkarte (C) in der Anschlußposition vorliegt, in welcher ein transversaler Hinterrand (98) einen Anschlag gegen den transversalen Hinterrand (96) der Aufnahme bildet und dass, die Innenseite (45), gegenüber der oberen Hauptwandung (44) vorliegend, und an welchen der Höcker (120) ausgebildet ist, an die Oberseite (68) des Sockels (66) des Steckers (64) angrenzt.

3. Elektronisches Anschlußgehäuse nach einem der vorhergehenden Ansprüche, **dadurch gekennzeichnet, dass** Ausziehmittel der Kontaktkarte (C) eine Nut (114) in der oberen Hauptwandung (44) umfassen, die sich parallel zu einer Einführungsrichtung (I) der Kontaktkarte (C) erstreckt, um ein Einwirken auf die Kontaktkarte (C) zu ermöglichen, bezüglich der Veranlassung eines Gleitens im inneren der Aufnahme (70) in der dem Herausziehen entsprechenden Richtung.

4. Elektronisches Anschlußgehäuse nach Anspruch 3, **dadurch gekennzeichnet, dass** die Nut (114) sich wenigstens teilweise an dem transversalen Hinterrand (98) der Kontaktkarte (C) erstreckt, wenn letztere sich in der eingeführten Position befindet, um ein Einführen eines Ausziehwerkzeuges zu ermöglichen, das mit dem transversalen Hinterrand der Kontaktkarte wechselwirkt.

5. Elektronisches Anschlußgehäuse nach einem der vorhergehenden Ansprüche, **dadurch gekennzeichnet, dass** dieses einen Schlitz (80) zum Einschieben oder Herausziehen der Kontaktkarte (C) in das Anschlußgehäuse, in einer Richtung (I), die im wesentlichen parallel zu Grundfläche der Kontaktkarte (C) verläuft, umfasst.

6. Elektronisches Anschlußgehäuse nach einem der vorhergehenden Ansprüche, **dadurch gekennzeichnet, dass** in der eingeführten Position, die Kontaktkarte (C) vollständig innenliegend im Anschlußgehäuse (30) angeordnet ist.

7. Elektronisches Anschlußgehäuse nach einem der vorhergehenden Ansprüche, **dadurch gekennzeichnet, dass** in der eingeführten Position in dem Anschlußgehäuse also in einer Anschlußposition bezüglich des Steckers (64) in der Aufnahme (70), die transversale Vorderkante (99) der Kontaktkarte vollständig innerhalb des Anschlußgehäuses (30) liegt, wobei sich ein leichter Rücksprung im Verhältnis zur Hauptkante des Einführschlitzes (80) bildet.

## Claims

1. Electronic connection unit (30) with upper (32) and lower (34) walls which delimit, between them, a cavity (48) inside which a connector (64) is arranged, comprising a support made of insulating material for electrically connecting to the unit a contact card (C) with integrated circuit(s), of the type which, in the vicinity of its front transverse edge (99), includes a cut-out flat (116) which, for certain applications, constitutes an orienting means for the position of the card (C) in the connector, **characterised in that** the upper main wall (44) includes, on its inner face (45), a boss (120) which, when the card (C) is in the inserted position, extends level with the cut-out flat (116), over a small height, to constitute a stop which extends in front of the cut-out flat (116) in order to prevent any accidental escape of this card, and **in that**, when the card is being extracted, by means of a slight elastic deformation of the corresponding part of the upper wall (44), the stop constituted by the boss (120) withdraws as the cut-out flat (116), then the upper face (73) of the card, (C) passes by.

2. Electronic connection unit according to the preceding claim, **characterised in that** the insulating material (66) includes an open housing (70) in its upper face (68), delimited by two edges (92, 94), parallel to the insertion direction of the card, and transversely by at least one rear edge (96), and which at least partly receives the card (C) including, on its lower main face (72), conductive zones (74) which interact with the contact ends (76) of electrical contact elements (78) arranged in the bottom of the housing (70) of the support, when the card (C) is in its connection position, in which its rear transverse edge (98) abuts against the rear transverse edge (96) of the housing, and **in that** the opposite inner face (45) of the upper wall (44), in which the boss (120) is formed, is adjacent to the upper face (68) of the support (66) of the connector (64).

3. Electronic connection unit according to any one of the preceding claims, **characterised in that** means for extracting the card (C) include a notch (114) which is formed in the upper wall (44) and extends parallel to the insertion direction (I) of the card (C) in order to make it possible to act on the card (C) with a view to causing it to slide inside the housing (70) in the direction corresponding to its extraction.

4. Electronic connection unit according to Claim 3, **characterised in that** the notch (114) extends at least partly in line with the rear transverse edge (98) of the card (C), when the latter is in the inserted position, in order to allow the insertion of an extraction tool which interacts with the rear transverse edge of the card.

5. Electronic connection according to any one of the preceding claims, **characterised in that** it includes a slot (80) for inserting, or extracting, the card (C) into/from the unit in a direction (I) substantially parallel to the plane of the card (C).

6. Electronic connection unit according to the preceding claim, **characterised in that**, in the inserted position, the card (C) is arranged entirely inside the unit (30).

7. Electronic connection unit according to the preceding claim, **characterised in that**, in the position in which it is inserted into the unit, and thus in the connection position in the housing (70) of the connector (64), the front transverse edge (99) of the card is situated entirely inside the unit (30), that is to say slightly set back inwards relative to the main edge of the insertion slot (80).
